**Europäisches Patentamt**

**European Patent Office**

**Office européen des brevets**

(19)

(11) Veröffentlichungsnummer: **0 070 511**
**B1**

(12) **EUROPÄISCHE PATENTSCHRIFT**

(45) Veröffentlichungstag der Patentschrift :
**19.12.84**

(21) Anmeldenummer : **82106295.7**

(22) Anmeldetag : **14.07.82**

(51) Int. Cl.³ : **G 03 C 1/68**, G 03 C 1/71,
**G 03 F 7/02**

(54) **Lichtempfindliche Aufzeichnungsmaterialien zur Herstellung von abriebs- und kratzfesten Tiefdruckformen sowie Verfahren zur Herstellung von Tiefdruckformen mittels dieser Aufzeichnungsmaterialien.**

(30) Priorität : **22.07.81 DE 3128949**

(43) Veröffentlichungstag der Anmeldung :
**26.01.83 Patentblatt 83/04**

(45) Bekanntmachung des Hinweises auf die Patenterteilung : **19.12.84 Patentblatt 84/51**

(84) Benannte Vertragsstaaten :
**BE DE FR GB IT NL SE**

(56) Entgegenhaltungen :
**DE-A- 2 926 236**
**US-A- 3 782 939**

(73) Patentinhaber : **BASF Aktiengesellschaft**
**Carl-Bosch-Strasse 38**
**D-6700 Ludwigshafen (DE)**

(72) Erfinder : **Lynch, John, Dr.**
**Bachusstrasse 15**
**D-6521 Monsheim (DE)**
Erfinder : **Elzer, Albert, Dr.**
**Pappelstrasse 4**
**D-6701 Otterstadt (DE)**

## Beschreibung

Die Erfindung betrifft lichtempfindliche Aufzeichnungsmaterialien mit einer photopolymerisierbaren und/oder photovernetzbaren Schicht, die zur Herstellung von Tiefdruckformen mit hoher Abriebs- und Kratzfestigkeit geeignet sind, sowie die Herstellung solcher Tiefdruckformen mittels dieser Aufzeichnungsmaterialien.

Beim Tiefdruck arbeitet man heutzutage im allgemeinen mit Druckformen, bei denen der Druckzylinder-Rohling aus Stahl von einem Grundkupfer-Mantel umgeben ist, wobei auf der Oberfläche des Grundkupfer-Mantels als eigentliche Druckschicht die sogenannte « Ballard »-Haut angeordnet ist. Bei dieser Ballard-Haut handelt es sich um eine verchromte Kupfer-Metallschicht, in der sich die für die Farbaufnahme notwendigen Vertiefungen (Näpfchen) befinden. Der Druck erfolgt in der Weise, daß die Druckform zunächst mit Druckfarbe eingefärbt wird und dann an einer Stahlrakel vorbeiläuft, wobei die Näpfchen mit Farbe gefüllt bleiben, die Oberflächenfarbe aber von der Druckform wieder abgerakelt wird. Anschließend läuft die Druckform unter Verwendung einer Gegendruckwalze über das zu bedruckende Material, wobei die Farbe aus den Näpfchen herausübertragen wird.

Die Auflagenhöhe bei diesem konventionellen Tiefdruck wird im allgemeinen durch den gleichmäßigen langsamen Abrieb der Chromschicht der Ballard-Haut oder durch Zerstören dieser Chromschicht durch Abplatzen feiner Schuppen begrenzt und liegt im Durchschnitt bei etwa 500 000 bis 5 000 000 Zylinderumdrehungen. Der Tiefdruck vereinigt damit hohe Lebensdauer und sehr gute Druckqualität und ermöglich im Vergleich zu anderen Druckverfahren insbesondere eine erheblich bessere Halbtonwiedergabe. Wegen der sehr komplizierten und aufwendigen Druckform-Herstellung (Aufgalvanisieren einer Kupferschicht auf den Kupfer ummantelten Druckzylinder-Rohling, mechanische Gravur oder Ätzen der Kupferschicht, Verchromen der gravierten oder geätzten Kupferschicht) ist der Einsatz des Tiefdrucks jedoch bis heute auf solche Anwendungen beschränkt, bei denen hohe Druckqualität und große Auflagenhöhe gefordert werden. Es ist erstrebenswert, das heute gebräuchliche Tiefdruck-Verfahren derart fortzuentwickeln, daß es in wirtschaftlicher Weise breiter und vielseitiger als bisher eingesetzt werden kann.

Zu diesem Zweck wird in der DE-A 27 52 500 die Verwendung einer Tiefdruckform mit Kunststoff-Druckschicht empfohlen, die hergestellt wird, indem man den Druckformträger mit einem Kunststoff beschichtet und in der Kunststoffschicht die farbaufnehmenden Vertiefungen durch mechanisches Gravieren ausbildet. Zur Verbesserung der Graviereigenschaften kann dabei die Kunststoffschicht pulverförmige anorganische Füllstoffe einer Teilchengröße von 0,01 bis 10 µm enthalten. Zur Vermeidung von Schrammen und Riefen auf der Oberfläche dieser Tiefdruckformen mit Kunststoff-Druckschicht sollen dabei gemäß der Lehre der DE-A 27 52 500 anstelle der sonst üblichen Stahlrakeln bei dem Tiefdruckverfahren aus Kunststoff hergestellte Rakeln eingesetzt werden. Die so erreichbaren Auflagenhöhen von ca. 50 000 Zylinderumdrehungen sind immer noch umbefriedigend. Auch ist die Herstellung der Tiefdruckformen wegen der notwendigen mechanischen Gravur der Kunststoff-Druckfläche nach wie vor aufwendig.

Weiterhin ist es bekannt, Tiefdruckformen mit einer Kunststoff-Druckschicht unter Einsatz von photopolymerisierbaren Materialien als das die Druckschicht bildende Material herzustellen. Hierbei werden die farbaufnehmenden Vertiefungen in der Oberfläche der Druckschicht — ähnlich wie bei der Herstellung von Hochdruck- und Flexodruck-Platten — durch bildmäßige Belichtung der photopolymerisierbaren Schicht und anschließendes Auswaschen der unbelichteten Bereiche erzeugt. Verfahren zur Herstellung von Tiefdruckformen auf Basis von photopolymerisierbaren Systemen werden u. a. in der DE-A 20 54 833, der DE-A 20 61 287 sowie der japanischen Patentschrift 41 361/72 beschrieben. Derartige Tiefdruckformen basieren im allgemeinen auf gleichen oder ähnlichen photopolymerisierbaren Systemen, wie sie für die Herstellung von photopolymeren Hochdruckplatten eingesetzt werden.

Der Einsatz von photopolymerisierbaren Systemen erlaubt zwar eine vergleichsweise schnelle, einfache und variable Herstellung von Tiefdruckformen in wirtschaftlicher Weise, doch haben sich die so hergestellten Tiefdruckformen bisher in Praxisversuchen als nicht hinreichend abriebs- und kratzfest erwiesen. Die beim Tiefdruck üblicherweise verwendeten Stahlrakeln schleifen sich nicht ohne Beschädigung der Kunststoff-Druckschicht auf den in der Druckmaschine eingestellten Anstellwinkel ein. Darüber hinaus verursachen sie durch Bildung von scharfen Kanten, Löchern, Spitzen etc. häufig Kratzpuren in der Kunststoff-Druckschicht und bewirken einen hohen Abrieb dieser Schicht. Auch durch Einsatz von Kunststoff-Rakeln gemäß der DE-A 27 52 500 kommt man zu keinen wesentlich besseren Ergebnissen, da die für die notwendigerweise dicken Kunststoff-Rakeln erforderlichen erheblich höheren Anpreßkräfte und -drücke zu einem starken Verschleiß führen. Daher kann auch mit diesen Tiefdruckformen nur eine Auflagenhöhe für den Qualitäts-Tiefdruck von maximal ca. 50 000 Zylinderumdrehungen erreicht werden.

Es ist wohl ebenfalls bereits bekannt, den photopolymerisierbaren Schichten von Aufzeichnungsmaterialien, die zur Herstellung von Hochdruckformen, Photoresists, Reliefbildern oder Offset-Platten geeignet sind und eingesetzt werden, feinteilige, mineralische Füllstoffe zuzusetzen. Diese Zusätze dienen entweder einfach als Füllstoff oder werden überwiegend zur Erzielung einer mattierten, aufgerauhten Oberfläche eingesetzt (vgl. u. a. DE-A 24 03 487 und DE-A 29 26 236). In der US-A 3 782 939 ist erwähnt, daß positiv-arbeitenden, lichtempfindlichen Elementen für die Herstellung von Photoresists anorganische Stoffe zugesetzt werden können, um die mechanischen Eigenschaften, beispielsweise auch die Abriebsfestigkeit, zu verbessern ; die Oberflächenrauhigkeit spielt jedoch bei Photoresist-Materialien keine Rolle. An die Oberfläche von Tiefdruckformen werden andererseits nicht nur bezüglich ihrer Abriebsfestigkeit, sondern insbesondere auch hinsichtlich ihrer Glätte, Ebenheit und Rillenfreiheit hohe Anforderungen gestellt, weshalb der Zusatz von feinteiligen mineralischen Füllstoffen zu photopolymerisierbaren Aufzeichnungsmaterialien für die Herstellung von Tiefdruckformen bisher als ungeeignet und nachteilig angesehen wurde.

Aufgabe der Erfindung ist es, eine Verbesserung für den mit Kunststoff-Druckschichten arbeitenden Tiefdruck aufzuzeigen, die es ermöglicht, die erwähnten Nachteile weitgehend zu vermeiden und erheblich größere Auflagenhöhen als bisher zu erzielen, ohne Einbußen in der Druckqualität hinnehmen zu müssen. Insbesondere ist es Aufgabe der vorliegenden Erfindung, eine einfache Möglichkeit zur Herstellung von Tiefdruckformen auf Basis von photopolymeren Systemen aufzuzeigen, wobei die Tiefdruckformen eine gute Abriebs- und Kratzfestigkeit bei gleichzeitig sehr guten sonstigen Druckeigenschaften besitzen sollen und bei deren Einsatz die für den konventionellen Tiefdruck gebräuchlichen und üblichen Stahlrakeln ohne Nachteil verwendet werden können.

Es wurde überraschend gefunden, daß diese Aufgabe gelöst wird, wenn man für die Herstellung der Tiefdruckformen mit Kunststoff-Druckschichten von einem lichtempfindlichen Aufzeichnungsmaterial ausgeht, welches in der die spätere Druckschicht bildenden, photopolymerisierbaren und/oder photovernetzbaren Schicht feinteilige, harte, abräsive Partikel enthält ; die Oberfläche der photopolymerisierbaren und/oder photovernetzbaren Schicht, die die Oberfläche der Druckschicht bildet, eine Rauhtiefe von < 2 μm besitzt, und das Aufzeichnungsmaterial nach der Belichtung und Entwicklung eine unter Last gemessene Vickers-Härte von mindestens 10 N/mm² aufweist.

Gegenstand der Erfindung ist dementsprechend ein lichtempfindliches Aufzeichnungsmaterial für die Herstellung von Tiefdruckformen mit einer auf einem dimensionsstabilen Träger aufgebrachten Schicht (S) eines in einer Entwicklerflüssigkeit löslichen bzw. dispergierbaren und durch Belichtung mit aktinischem Licht in dieser Entwicklerflüssigkeit unlöslich bzw. nicht mehr dispergierbar werdenden, vorzugsweise festen, photopolymerisierbaren und/oder photovernetzbaren Materials. Das lichtempfindliche Aufzeichnungsmaterial gemäß der Erfindung ist dadurch gekennzeichnet, daß das photopolymerisierbare und/oder photovernetzbare Material zumindest in einem Schichttiefenbereich von 1 bis 50 μm, gemessen von der Oberfläche der Schicht (S), die die spätere Oberfläche der Druckform bildet, feinteilige, abräsive Partikel in einer solchen Menge enthält, daß diese 2 bis 50 Gew.% des die abräsiven Partikel enthaltenden photopolymerisierbaren und/oder photovernetzbaren Materials ausmachen, wobei die mittlere Teilchengröße der abräsiven Partikel im Bereich von 0,1 bis 6 μm liegt, höchstens 5 % der abräsiven Partikel Lösungsausdehnungen größer als 10 μm aufweisen und die abräsiven Partikel eine Härte von > 4,0 auf der Mohs'schen Härteskala aufweisen ; und daß die Oberfläche der Schicht (S), die die spätere Oberfläche der Druckform wird, eine Rauhtiefe von weniger als 2 μm besitzt und daß die Schicht (S) nach dem Belichten, Entwickeln, Trocknen sowie gegebenenfalls Nachbelichten und/oder Härten mindestens in dem die farbaufnehmenden Vertiefungen enthaltenden Schichtdickenbereich eine unter Last gemessene Vickers-Härte von mindestens 10 N/mm² aufweist.

Gegenstand der Erfindung sind weiterhin Verfahren zur Herstellung von Tiefdruckformen mittels dieser lichtempfindlichen Aufzeichnungsmaterialien sowie spezielle Ausgestaltungsformen der lichtempfindlichen Aufzeichnungsmaterialien und der Verfahren zur Herstellung der Tiefdruckform, wie sie sich aus der nachfolgenden detaillierten Beschreibung ergeben.

Es war äußerst überraschend, daß mit den in Rede stehenden lichtempfindlichen Aufzeichnungsmaterialien nicht nur Tiefdruckformen hergestellt werden können, deren Abriebs- und Kratzfestigkeit dem Niveau der verchromten Ballard-Häute entspricht, sondern daß diese Tiefdruckformen gleichzeitig eine derart glatte Oberfläche aufweisen, daß sie ohne Nachteile und Qualitätseinbußen für den Qualitätstiefdruck eingesetzt werden können. Man mußte viel eher davon ausgehen, daß die in der photopolymerisierbaren und/oder photovernetzbaren Schicht (S) enthaltenen abräsiven Partikel beim Entwickeln der durch eine Bildvorlage belichteten Aufzeichnungsmaterialien mit der Entwicklerflüssigkeit zu einer derart großen Oberflächenrauhigkeit der Druckformen führen, daß diese für den Tiefdruck ungeeignet sind. Darüber hinaus war es in keiner Weise vorherzusehen und höchst überraschend, daß beim Tiefdruck mit den erfindungsgemäß hergestellten Tiefdruckformen die konventionellen, gebräuchlichen Stahlrakeln eingesetzt werden können und daß sich diese Stahlrakeln gleichmäßig an der Oberfläche der Druckform abschleifen, ohne daß es durch die scharfen Kanten, Spitzen etc. der abräsiven Partikel zur Ausbildung von Kratzern, Riefen oder sonstigen Beschädigungen an der Rakel oder der Kunststoff-Druckschicht kommt. Es lassen sich somit erfindungsgemäß einfach, schnell und wirtschaftlich Tiefdruckformen herstellen, die in ihrer Qualität weitgehend den konventionellen Tiefdruck-Formen mit Ballard-Haut entsprechen.

Unter Tiefdruckformen werden hierbei Druckplatten, Druckfolien oder Druckzylinder verstanden, die die farbführenden Bildteile für den Druck als Vertiefungen in der Oberfläche enthalten. Bei den erfindungsgemäßen Tiefdruckformen befinden sich diese farbaufnehmenden Vertiefungen in der photopolymeren Schicht, wobei diese photopolymere Druckschicht haftfest auf einen üblicherweise aus Metall hergestellten Druckformträger, beispielsweise eine Stahlplatte oder einen Stahlzylinder, aufgebracht ist. Die Dicke der photopolymeren Kunststoff-Druckschicht und somit auch die Dicke der photopolymerisierbaren und/oder photovernetzbaren Schicht (S) der lichtempfindlichen Aufzeichnungsmaterialien liegt im allgemeinen im Bereich von 30 bis 500 μm, vorzugsweise im Bereich von 50 bis 250 μm. Die Tiefe der Näpfchen, d. h. der farbaufnehmenden Vertiefungen, beträgt im Normalfall einige wenige μm, z. B. 2 bis 3 μm, für die Näpfchen mit der geringsten Tiefe und reicht bis zu Werten von etwa 10 bis 100 μm, vorzugsweise von etwa 20 bis 60 μm, für die tiefsten Näpfchen.

Als in einer Entwicklerflüssigkeit lösliches bzw. dispergierbares und durch Belichtung mit aktinischem Licht darin unlöslich bzw. nicht mehr dispergierbar werdendes photoempfindliches Material für die Schicht (S) der lichtempfindlichen Aufzichnungsmaterialien kommen die an sich bekannten photopolymerisierbaren und/oder photovernetzbaren Systeme auf Basis von Verbindungen mit mindestens einer photopolymerisierbaren oder photovernetsbaren Doppelbindung in Frage. Das Unlöslichwerden dieser Materialien in den Entwicklerflüssigkeiten beruht auf einer strahlungsinitiierten Polymerisation bzw. Vernetzung der ungesättigten Verbindungen.

Zu den photopolymerisierbaren und/oder photovernetzbaren Materialien, die für den Zweck der Erfindung in Betracht kommen, gehören z. B. Photopolymerisationsinitiatoren enthaltende Gemische mit photopolymerisierbaren, olefinisch ungesättigten, niedermolekularen Verbindungen als einem Mischungsbestandteil. Ebenso können Polymere, die einen hinreichenden Anteil an photopolymerisierbaren, olefinischen Doppelbindungen eingebaut enthalten, zusammen mit mindestens einem Photopolymerisationsinitiator — auch ohne Zusatz von photopolymerisierbaren niedermolekularen Verbindungen — eingesetzt werden. Vorzugsweise besteht das photopolymerisierbare und/oder photovernetzbare Material der Schicht (S) der lichtempfindlichen Aufzeichnungsmaterialien im wesentlichen aus mindestens einem gesättigten und/oder ungesättigten Polymeren ; mindestens einer photopolymerisierbaren, olefinisch ungesättigten, niedermolekularen Verbindung ; mindestens einem Photopolymerisationsinitiator sowie gegebenenfalls weiteren Zusatzstoffen und/oder Hilfsmitteln.

Als Polymere, im allgemeinen das Basismaterial, für die photopolymerisierbaren und/oder photovernetzbaren Materialien sind die in Entwincklerlösungsmitteln löslichen synthetischen Polymeren geeignet, die zur Herstellung von photopolymerisierbaren Schichten, insbesondere die Herstellung von Reliefformen für Druckzwecke bekannt und üblich sind. Beispielhaft seien genannt Vinylpolymerisate, wie Polyvinylchlorid, Vinylidenchloridpolymerisate, Copolymere aus Vinylchlorid und Vinylestern von Monocarbonsäuren mit 2 bis 11 Kohlenstoffatomen und gegebenenfalls Vinylalkohol ; Polymere aus überwiegenden Mengen von olefinisch ungesättigten Carbonsäuren mit 3 bis 5 Kohlenstoffatomen und/oder deren Ester und/oder deren Amide, z. B. Polymerisate von Acrylsäure, Methacrylsäure, Acrylamid, Methacrylamid, Acrylaten oder Methacrylaten von Alkanolen mit 1 bis 12 Kohlenstoffatomen oder aliphatischen Diolen und Polyolen, wie Ethylenglykol, 1,4-Butandiol oder Glycerin. Ferner sind geeignet Polymere auf der Basis von Styrol oder Vinylestern von Monocarbonsäuren mit 2 bis 11 Kohlenstoffatomen, wie Vinylacetat und Vinylchloracetat ; Polyformaldehyd ; Polyimide und Polyamidimide ; Polyurethane, Polyetherurethane, Polyesterurethane, vorzugsweise mit eingebauten Harnstoffgruppierungen ; Melaminformaldehyd- oder Phenolformaldehyd-Harze ; sowie im besonderen die üblichen ungesättigten Polyesterharze aus mehrwertigen, insbesondere zweiwertigen Carbonsäuren und mehrwertigen, insbesondere zweiwertigen Alkoholen. Als ungesättigte Polyester kommen beispielsweise solche in Betracht, deren Säurekomponente sich von Maleinsäure, Fumarsäure, Itaconsäure, Citraconsäure oder Mesaconsäure neben anderen ungesättigten und/oder gesättigten mehrwertigen Carbonsäuren ableitet und deren Alkoholkomponente beispielsweise von Alkandiolen, wie Ethylenglykol, 1,2- oder 1,3-Propandiol, Butylenglykol-1,3, Butandiol-1,4, Hexandiol-1,6, Diethylenglykol, Triethylenglykol, Tetraethylenglykol oder Neopentylglykol herrührt.

Als vorteilhafte Basiskomponente für die photopolymerisierbaren und/oder photovernetzbaren Materialien haben sich insbesondere Vinylalkohol-Polymer mit $CH_2CH(OH)$-Struktureinheiten in der Polymerhauptkette erwiesen sowie deren in Wasser oder wäßrigen Entwicklerflüssigkeiten lösliche oder dispergierbare Copolymerisate und Derivate, wie Ester, Ether oder Acetate. Besonders geeignet sind die bekannten verseiften Polyvinylester von aliphatischen Monocarbonsäuren mit 1 bis 4 C-Atomen, wie Polyvinylacetate oder Polyvinylpropionate, deren mittlerer Polymerisationsgrad 200 bis 3 000 und insbesondere 250 bis 750, und deren Verseifungsgrad 65 bis etwa 100 und insbesondere 80 bis 88 Mol.% beträgt. Auch Gemische von verseiften Vinylester-Polymeren oder -Copolymeren mit unterschiedlichem Polymerisationsgrad und/oder unterschiedlichem Verseifungsgrad können angewandt werden. Desweiteren seien in diesem Zusammenhang die Umsetzungsprodukte von Vinylalkohol-Polymeren mit Acryl- und/oder Methacrylsäureanhydrid erwähnt, wobei diese Umsetzungsprodukte im allgemeinen 3 bis 30 Gew.% bezogen auf das Umsetzungsprodukt, an Acryloyl- oder Methacryloyl-Gruppen eingebaut enthalten, als auch die wasserlöslichen Umsetzungsprodukte von Vinylalkohol-Polymeren mit Ethylenoxid, wobei der Anteil der Ethylenoxid-Einheiten im oxethylierten Vinylalkohol-Polymer 5 bis 75 Gew.%, insbesondere 10 bis 60 Gew.%, beträgt. Diese Umsetzungsprodukte von Vinylalkohol-Polymeren können als alleinige Polymer-Komponente in den photopolymerisierbaren und/oder photovernetzbaren Materialien enthalten sein ; sie können aber auch in Mischung mit anderen Vinylalkohol-Polymeren, insbesondere den erwähnten verseiften Polyvinylestern vorliegen, wobei dann der Anteil der Umsetzungsprodukte des Polyvinylalkohols vorteilhaft mindestens 30 Gew.%, bezogen auf die gesamten in der Mischung enthaltenen Vinylalkohol-Polymeren, beträgt. Darüber hinaus ist es möglich, daß die genannten Vinylalkohol-Polymeren oder -Copolymeren und/oder deren Derivate mit bis zu etwa 30 Gew.%, bezogen auf den Polymeranteil des jeweiligen photopolymerisierbaren und/oder photovernetzbaren Materials, an verträglichen Melamin-Formaldehyd-Harzen, Harnstoff-Formaldehyd-Harzen oder Phenol-Formaldehyd-Harzen abgemischt sind.

Besonders geeignete Polymere für die photopolymerisierbaren und/oder photovernetzbaren Materialien sind auch die in üblichen organischen und insbesondere alkoholischen Lösungsmitteln (als Entwicklerflüssigkeit) löslichen linearen synthetischen Polyamide mit wiederkehrenden Amidgruppen in der Molekülhauptkette. Von ihnen werden die Mischpolyamide bevorzugt, die in üblichen Lösungsmitteln oder Lösungsmittelgemischen, insbesondere in niederen aliphatischen Alkoholen, wie z. B. Ethanol oder n-Propanol, oder Gemischen von diesen Alkoholen mit Wasser löslich sind. Dies sind z. B. Mischpolyamide, die in üblicher Weise durch Polykondensation oder Polymerisation aus zwei oder mehreren Lactamen mit 5 bis 13 Ringgliedern hergestellt worden sind. Solche Lactame sind beispielsweise Pyrrolidon, Caprolactam, Önantholactam, Capryllactam, Laurinlactam bzw. entsprechende C-substituierte Lactame, wie ε-Methyl-ε-caprolactam, ε-Ethyl-ε-caprolactam oder δ-Ethylönantholactam. Anstelle der Lactame können die ihnen zugrundeliegenden Aminocarbonsäuren polykondensiert worden sein. Weitere geeignete Mischpolyamide sind Polykondensationsprodukte aus Salzen vom Typ Diamin/Dicarbonsäure, die aus mindestens 3 polyamidbildenden Ausgangsstoffen hergestellt worden sind. Hierfür geeignete Dicarbonsäuren bzw. Diamine sind bevorzugt aliphatische Dicarbonsäuren mit 4 bis 20 Kohlenstoffatomen, wie Adipinsäure, Korksäure, Sebacinsäure, Dodecandicarbonsäure sowie entsprechende Substitutionsprodukte, wie $\alpha,\alpha$-Diethyladipinsäure, $\alpha$-Ethylkorksäure, Heptadecandicarbonsäure-1,8 oder Heptadecandicarbonsäure-1,9 bzw. deren Gemische sowie aliphatische oder aromatische Ringsysteme enthaltende Dicarbonsäuren. Geeignete Diamine sind insbesonders aliphatische oder cycloaliphatische Diamine mit 2 primären und/oder sekundären Aminogruppen, insbesondere mit 4 bis 20 Kohlenstoffatomen, wie Pentamethylendiamin, Hexamethylendiamin, Heptamethylendiamin, Octamethylendiamin oder C-und/oder N-substituierte Derivate dieser Amine, wie N-Methyl-N'-ethyl-hexamethylendiamin, 1,6-Diamino-4-methylhexan, 4,4'-Diaminodicyclohexylmethan oder 2,2-(4,4'-Diaminodicyclohexyl)-propan, ferner aromatische Diamine, wie m-Phenylendiamin, m-Xylilendiamin oder 4,4'-Diaminodiphenylmethan, wobei bei allen Ausgangsstoffen die Brückenglieder zwischen den beiden Carbonsäuregruppen bzw. Aminogruppen auch durch Heteroatome, z. B. Sauerstoff-, Stickstoff- oder Schwefelatome unterbrochen sein können. Besonders geeignete Mischpolyamide sind solche, die durch Mischkondensation eines Gemisches aus einem oder mehreren Lactamen, insbesondere Caprolactam und mindestens einem Dicarbonsäure/Diamin-Salz hergestellt worden sind, z. B. aus ε-Caprolactam, Hexamethylendiamonium-Adipat und 4,4'-Diaminodicyclohexylmethan/Adipinsäure-Salz.

Als photopolymerisierbare, olefinisch ungesättigte niedermolekulare Verbindungen kommen die bekannten Monomeren und Oligomeren mit einem Molekulargewicht unter 2 000 in Frage, die für polymere Bindemittel enthaltende photopolymerisierbare und/oder photovernetzbare Materialien an sich bekannt sind, wobei sich natürlich Art und Menge der photopolymerisierbaren niedermolekularen Verbindungen nach dem mitverwendeten polymeren Bindemittel richten, mit dem sie verträglich sein sollen. Bevorzugt sind photopolymerisierbare niedermolekulare Verbindungen mit 2 oder mehr ethylenisch ungesättigten photopolymerisierbaren Doppelbindungen allein oder deren Mischungen mit Monomeren mit nur einer olefinisch ungesättigten photopolymerisierbaren Doppelbindung, wobei der Anteil der Monomeren mit nur einer Doppelbindung im allgemeinen etwa 5 bis 50 Gew.% und bevorzugt 5 bis 30 Gew.% der Gesamtmonomerenmenge beträgt. Es ist unter bestimmten Voraussetzungen selbstverständlich auch möglich, daß als photopolymerisierbare niedermolekulare Verbindungen überwiegend oder nur solche eingesetzt werden, die nur eine photopolymerisierbare Doppelbindung im Molekül enthalten, insbesondere dann, wenn das in den photopolymerisierbaren und/oder photovernetzbaren Materialien enthaltene Polymer selber einen hohen Anteil an photopolymerisierbare Doppelbindungen enthält, wie z. B. im Fall der acryloierten und/oder methacryloierten Vinylalkohol-Polymerisate. Im allgemeinen haben die photopolymerisierbaren niedermolekularen Verbindungen einen Siedepunkt von über 100 °C bei Atmosphärendruck.

Als Beispiele für photopolymerisierbare olefinisch ungesättigte niedermolekulare Verbindungen seien genannt : Mono-, Di- und Polyacrylate und -methacrylate, wie sie durch Veresterung von Acrylsäure oder Methacrylsäure mit ein- oder mehrwertigen niedermolekularen Alkoholen hergestellt werden können. Hierzu gehören u. a. die Di- und Tri-(meth)acrylate von Ethylenglykol, Diethylenglykol, Triethylenglykol, Polyethylenglykolen mit einem Molekulargewicht bis etwa 500, 1,2-Propandiol, 1,3-Propandiol, Polypropylenglykolen mit einem Molekulargewicht bis etwa 500, Neopentylglykol (2,2-Dimethylpropandiol), 1,4-Butandiol, 1,1,1-Trimethylolpropan, Glycerin oder Pentaerythrit ; ferner die Monoacrylate und Monomethacrylate solcher Diole oder Polyole, wie z. B. Ethylenglykol-mono-(meth)acrylat, 1,2-Propandiol-mono-(meth)acrylat, 1,3-Propandiol-mono-(meth)-acrylat und das Di-, Tri- oder Tetraethylenglykol-mono-(meth)-acrylat. Weiterhin kommen photopolymerisierbare, olefinisch ungesättigte niedermolekulare Verbindungen in Betracht, die Urethangruppen und/oder Amidgruppen enthalten, wie die aus aliphatischen Diolen der vorstehend genannten Art, organischen Diisocyanaten, wie z. B. Hexamethylendiisocyanat, Toluylendiisocyanat und isophorondiisocyanat, und Hydroxyalkyl-(meth)acrylaten der oben genannten Art hergestellten niedermolekularen Verbindungen. Genannt seien ferner auch Acrylsäure selber, Methacrylsäure selber, (Meth)acrylate von Monoalkanolen mit 1 bis 6 C-Atomen, Mono- und Bis-(meth)-acrylamide von aliphatischen oder aromatischen Diaminen mit 2 bis 8 C-Atomen, wie von Ethylendiamin, Propylendiamin, Butylendiamin, Pentamethylendiamin, Hexamethylendiamin, Octamethylendiamin oder Xylylendiamin, als auch Derivate der (Meth)acrylamide, z. B. N-Hydroxymethyl-(meth)acrylamid, oder insbesondere die Umsetzungsprodukte von 2 Mol N-Hydroxymethyl-(meth)acrylamid mit einem Mol eines aliphatischen Diols, z. B. Ethylenglykol oder Propylenglykol.

Die Auswahl der geeigneten Monomeren richtet sich neben den in den photopolymerisierbaren und/oder photovernetzbaren Materialien enthaltenen Polymeren auch nach den angestrebten Eigenschaften des Endproduktes und ist dem Fachmann geläufig. So sind beispielsweise bei photopolymerisierbaren und/oder photovernetzbaren Materialien auf Polyesterharz-Basis, insbesondere bei den ungesättigte Polyesterharze enthaltenden Materialien, die oben erwähnten Di- und Polyacrylate und/oder -methacrylate besonders geeignet. Neben diesen (Meth)-acrylaten können dabei auch noch Allylverbindungen, wie z. B. Maleinsäurediallylester, Allylacrylat, Diallylphthalat, Trimellithsäure-di- und -triallylester eingesetzt werden. Werden als polymere Bindemittel in den photopolymerisierbaren und/oder photovernetzbaren Materialien Vinylalkoholpolymerisate eingesetzt, eignen sich als Monomere besonders die wasserlöslichen Monomere, wie z. B. die Hydroxyalkyl-(meth)-acrylate, die Mono- oder Di-(meth)acrylate von Polyethylenglykolen oder Mischungen hiervon mit Di- oder Poly-(meth)acrylaten der oben genannten Art. Wählt man photopolymerisierbare und/oder photovernetzbare Materialien mit Polyamiden als polymerem Bindemittel, so eignen sich von den genannten Monomerarten neben den Di- und Poly-(meth)acrylaten besonders solche, die zusätzlich zu den Doppelbindungen noch Amid und/oder Urethangruppen enthalten, die (Meth)acrylamide sowie insbesondere die Derivate der (Meth)acrylamide.

Die photopolymerisierbaren und/oder photovernetzbaren Materialien enthalten die Polymeren und die photopolymerisierbaren olefinisch ungesättigten niedermolekularen Verbindungen im allgemeinen in einer Menge von etwa 50 bis 90 Gew.% bzw. von 10 bis 50 Gew.%, jeweils bezogen auf die Summe von Polymer und photopolymerisierbarer, niedermolekularer Verbindung. Der Anteil der photopolymerisierbaren niedermolekularen Verbindungen kann in einzelnen Fällen auch größer oder kleiner sein. So ist es beispielsweise möglich, den Anteil der photopolymerisierbaren niedermolekularen Verbindungen unter 10 Gew.%, sogar gegebenenfalls bis auf 0 % abzusenken, wenn in den photopolymerisierbaren und/oder photovernetzbaren Materialien ungesättigte Polymere mit einem hinreichend hohen Gehalt an photopolymerisierbaren Doppelbindungen enthalten sind.

Als Photopolymerisationsinitiatoren, die in den photopolymerisierbaren und/oder photovernetzbaren Materialien im allgemeinen in Mengen von 0,05 bis 10 Gew.% und insbesondere von 0,5 bis 5 Gew.%, bezogen auf das gesamte photopolymerisierbare und/oder photovernetzbare Material, enthalten sind, kommen die bekannten und üblichen Photopolymerisationsinitiatoren und Systeme für die Auslösung einer Photopolymerisation bei Bestrahlung mit aktinischem Licht in Frage, wie sie hinreichend in der einschlägigen Fachliteratur beschrieben sind. Genannt seien z. B. Acyloine und deren Derivate, wie Benzoin, Benzoinalkylether, z. B. Benzoinmethylether oder Benzoinisopropylether, α-Methylolbenzoin und dessen Ether oder α-Methylbenzoin und dessen Ether ; 1,2-Diketone und deren Derivate wie Diacetyl, Benzil, Benzilketale wie Benzildimethylketal, Benzilmethylethylketal, Benzilmethylbenzylketal oder Benzylethylenglykol-monoketal ; Acylphosphinoxid-Verbindungen, insbesondere Acyl-diarylphosphinoxide und speziell Acyldiphenylphosphinoxide, deren Acylrest sich von einer tertiären aliphatischen oder cycloaliphatischen Carbonsäure oder von einer mindestens in 2,6-Stellung substituierten Benzoesäure ableitet, wie sie in der DE-A 29 09 992 ausführlich beschrieben sind.

Die Photopolymerisationsinitiatoren können allein oder in Mischung miteinander oder auch in Mischung mit Aktivatoren, wie z. B. tertiären Aminen, eingesetzt werden. Vorteilhafterweise werden möglichst aktive Photopolymerisationsinitiatoren verwendet. Überraschenderweise wurde gefunden, daß Tiefdruckformen mit besonders glatter Oberfläche dann erhalten werden, wenn in den photopolymerisierbaren und/oder photovernetzbaren Materialien neben Photoinitiatoren, die im aktinischen Wellenlängenbereich, insbesondere von 300 bis 380 nm, niedrig absorbierend sind, wie z. B. die genannten Benzoine, Benzoinether, Benzil oder Benzilmonoketale, zusätzlich solche Photoinitiatoren enthalten sind, deren Extinktionskoeffizienten $\varepsilon$ bei 360 nm > 500 cm²/mMol, insbesondere > 5 000 cm²/mMol sind. Als Beispiele für solche stark absorbierenden Coinitiatoren seien genannt das 4,4'-Bis(N-dimethylamino)benzophenon (Michlers Keton) sowie Derivate von Michlers Keton, beispielsweise die in der EP-A1-0 000 342 beschriebenen 4,4'-Bis(N-hydroxyalkyl-N-alkylaminobenzophenone, wie das 4,4'-Bis(N-β-hydroxyethyl-N-methylamino)benzophenon, das 4,4'-Bis(N-β-hydroxyethyl-N-ethyl-amino)benzophenon, das 4,4'-Bis(N-β-hydroxyethyl-N-propylamino) benzophenon, das 4,4'-Bis(N-β-hydroxypropyl-N-methyl-amino)benzophenon, das 4,4'-Bis(N-hydroxypropyl-N-ethyl-amino)benzophenon. Für die vorteilhafte Initiatorkombination von stark absorbierenden und niedrig absorbierenden Initiatoren können die für Michlers Keton bekannten molaren Verhältnisse und Mengen angewandt werden. Üblicherweise sind die stark absorbierenden Initiatoren in den photopolymerisierbaren und/oder photovernetzbaren Materialien — je nach Dicke der diese Initiatoren enthaltenden Schicht — in Mengen von etwa 0,05 bis 0,4 Gew.%, vorzugsweise von 0,1 bis 0,25 Gew.%, enthalten, wobei sich das Verhältnis von stark absorbierendem Initiator zu niedrig absorbierendem Coinitiator nach den angestrebten Belichtungseigenschaften richtet und beispielsweise etwa 1 : 10 betragen kann.

Es ist oft zweckmäßig, den photopolymerisierbaren und/oder photovernetzbaren Materialien andere übliche Hilfsstoffe und Zusätze zuzugeben. Hierzu gehören insbesondere die Inhibitoren gegen die thermische Polymerisation, wie Hydrochinon, p-Methoxyphenol, m-Dinitrobenzol, p-Chinon, Methylenblau, β-Naphthol, N-Nitrosamine, wie N-Nitrosodiphenylamin oder die Salze, insbesondere die Alkali- und Aluminiumsalze des N-Nitroso-cyclohexyl-hydroxylamins. Diese Inhibitoren werden im allgemeinen in Mengen von 0,01 bis 2,0 Gew.%, bezogen auf das gesamte photopolymerisierbare und/oder photovernetzbare Material, verwendet. Die Materialien können darüber hinaus als weitere Zusätze beispielsweise Weichmacher, Farbstoffe, Pigmente oder dergleichen enthalten.

Ein wesentliches Merkmal der vorliegenden Erfindung besteht darin, daß die lichtempfindlichen Aufzeichnungsmaterialien für die Herstellung der Tiefdruckformen in der photopolymerisierbaren und/oder photovernetzbaren Schicht (S) feinteilige, harte, abrasive Partikel enthalten. Die abrasiven Partikel sollen kompakt sein, haben im allgemeinen eine unregelmäßige Form und besitzen vorteilhafterweise scharfe Kanten, Ecken oder Spitzen. Die mittlere Teilchengröße der abrasiven Partikel soll im Bereich von 0,1 bis 6 μm liegen, wobei höchstens 5 %, vorzugsweise weniger als 1 % der abrasiven Partikel Längsausdehnungen größer 10 μm haben dürfen. Die mittlere Teilchengröße der abrasiven Partikel kann nach den bekannten Methoden, insbesondere der Sedimentationsanalyse, ermittelt werden. Unter Längsausdehnung der Partikel wird der projezierte Abstand zwischen zwei Punkten der Partikeloberfläche verstanden. Die Längsausdehnungen der Teilchen können z. B. nach den üblichen mikroskopischen Meßmethoden bestimmt werden.

Enthält die photopolymerisierbare und/oder photovernetzbare Schicht (S) der lichtempfindlichen Aufzeichnungsmaterialien wesentliche Mengen an abrasiven Partikeln mit Längsausdehnungen größer 10 μm, ist es im allgemeinen nicht mehr ohne weitere, zusätzliche Maßnahmen möglich, aus den lichtempfindlichen Aufzeichnungsmaterialien Tiefdruckformen mit der geforderten geringen Oberflächenrauhigkeit herzustellen. Sind die abrasiven Partikel zu feinteilig, d. h. besitzen wesentliche Mengen der zugesetzten abrasiven Partikel eine Teilchengröße < 0,01 μm, zeigen die entsprechenden Tiefdruckformen keine optimale Abriebs- und Kratzfestigkeit ihrer Druckoberfläche. Die Härte der abrasiven Partikel soll > 4,0 auf der Mohs'schen Härteskala betragen. Vorteilhaft liegt die Härte der abrasiven Partikel bei 6 oder mehr der Mohs'schen Härteskala. Bei den abrasiven Partikeln, die für den Zweck der Erfindung in Betracht kommen, handelt es sich insbesondere um mineralische Füllstoffe und Pigmente, wie z. B. Siliciumdioxide, insbesondere Quarzmehl und Kristabolit ; Silikate, insbesondere Aluminiumsilikate, Silikatgläser ; Aluminiumoxide, insbesondere Korund ; Titandioxid, Siliciumcarbid, Wolframcarbid u. a. Die feinteiligen, abrasiven Partikel können dabei in an sich bekannter Weise auch oberflächlich behandelt oder beschichtet sein, um beispielsweise die Dispergierbarkeit und/oder die Haftung in der photopolymerisierbaren und/oder photovernetzbaren Schicht (S) zu verbessern.

Vorteilhafterweise werden solche abrasiven Partikel verwendet, die für aktinisches Licht weitgehend durchlässig sind, wobei es desweiteren von Vorteil ist, wenn die Brechungsindices der abrasiven Partikel und des für die Schicht (S) eingesetzten photopolymerisierbaren und/oder photovernetzbaren Materials aneinander angeglichen worden sind. Für diesen Fall hat sich der Einsatz von Siliciumdioxiden, besonders Quarzmehl und Kristabolit, als abrasive Partikel als sehr günstig erwiesen.

Die abrasiven Partikel können in der gesamten photopolymerisierbaren und/oder photovernetzbaren Schicht (S) enthalten und in dieser gleichmäßig verteilt sein. Um Tiefdruckformen mit einer abriebs- und kratzfesten Druckschicht zu erhalten, hat es sich jedoch als ausreichend erwiesen, wenn die abrasiven Partikel nur in einer dünnen Oberflächenzone der Druckschicht enthalten sind, wobei der darunterliegende Bereich der Druckschicht keine abrasiven Partikel zu

enthalten braucht. Demzufolge ist es auch möglich, daß die abräsiven Partikel in der photopolymerisierbaren und/oder photovernetzbaren Schicht (S) der lichtempfindlichen Aufzeichnungsmaterialien nur in einer dünnen Oberflächenzone von etwa 1 bis 50 μm, vorzugsweise von 5 bis 20 μm Dicke, gemessen von der Oberfläche der Schicht (S), die die spätere Oberfläche der Druckschicht bildet, enthalten sind und der restliche Teil der photopolymerisierbaren und/oder photovernetzbaren Schicht (S) keine abräsiven Partikel enthält. Es ist selbstverständlich, daß in diesem Fall, in dem die Schicht (S) die abräsiven Partikel nur in einer dünnen Oberflächenzone enthält, es sich hierbei um die Oberflächenzone der Schicht (S) handelt, die die spätere Druckschicht der Tiefdruckform darstellt.

Wenn die die abräsiven Partikel enthaltende Oberflächenzone der photopolymerisierbaren und/oder photovernetzbaren Schicht (S) eine Schichtdickentiefe von 50 μm, insbesondere aber auch schon von 20 μm, gemessen von der Oberfläche der Schicht (S), die die spätere Oberfläche der Druckschicht bildet, übersteigt, was im allgemeinen dann der Fall ist, wenn die gesamte Schicht (S) die abräsiven Partikel in gleichmäßiger Verteilung enthält, ist es — wie oben bereits erwähnt — vorteilhaft oder gegebenenfalls auch notwendig, für aktinisches Licht durchlässige abräsive Partikel einzusetzen und die Brechungsindices der abräsiven Partikel und des photopolymerisierbaren und/oder photovernetzbaren Materials aneinander anzugleichen. In den Fällen, in denen die abräsiven Partikel nur in einer Oberflächenzone der photopolymerisierbaren und/oder photovernetzbaren Schicht (S) von 1 bis 50 μm, vorzugsweise 5 bis 20 μm Dicke enthalten sind, können ohne wesentliche Beeinträchtigung der Belichtungseigenschaften der lichtempfindlichen Aufzeichnungsmaterialien auch lichtstreuende abräsive Partikel eingesetzt werden, d. h. die Brechungsindices der abräsiven Partikel und des die abräsiven Partikel enthaltenden photopolymerisierbaren und/oder photovernetzbaren Materials können verschieden sein. Die feinteiligen, abräsiven Partikel können hierbei für aktinisches Licht durchlässig, also nicht absorbierend sein, sie können das aktinische Licht aber auch absorbieren. Sind in den photopolymerisierbaren und/oder photovernetzbaren Materialien feinteilige abräsive Partikel enthalten, die für aktinisches Licht nicht durchlässig sind, d. h. dieses stark absorbieren, so sind diese abräsiven Partikel auch dann vorteilhafterweise nur in einer Oberflächenzone von 1 bis 50 μm, vorzugsweise 5 bis 20 μm Dicke der Schicht (S) enthalten, wenn die Brechungsindices der abräsiven Partikel und des diese Partikel enthaltenden photopolymerisierbaren und/oder photovernetzbaren Materials aneinander angeglichen sind. Werden lichtstreuende und/oder absorbierende abräsive Partikel eingesetzt, so ist es sinnvoll und günstig, wenn die Dicke der die abräsiven Partikel enthaltenden Oberflächenzone dem Maß der Lichtstreuung und -absorption angepaßt wird.

Die abräsiven Partikel liegen in der photopolymerisierbaren und/oder photovernetzbaren Schicht (S) in einer Menge von 2 bis 50 Gew.%, vorzugsweise von 5 bis 30 Gew.%, vor, bezogen auf den Teil der Schicht (S), der die abräsiven Partikel enthält ; d. h., in dem Fall, in dem die gesamte Schicht (S) die abräsiven Partikel enthält, sind die Angaben auf das gesamte photopolymerisierbare und/oder photovernetzbare Material bezogen, und in dem Fall, in dem die abräsiven Partikel nur in einer Oberflächenzone der Schicht (S) enthalten sind, sind diese Angaben auf den Teil des photopolymerisierbaren und/oder photovernetzbaren Materials bezogen, der diese die abräsiven Partikel enthaltende Oberflächenzone darstellt. Geeignete abräsive Partikel enthaltende photopolymerisierbare und/oder photovernetzbare Materialien bestehen somit im allgemeinen im wesentlichen aus 30 bis 90 Gew.% an Polymeren als Basismaterial, 6 bis 50 Gew.% an photopolymerisierbaren, olefinisch ungesättigten, niedermolekularen Verbindungen, 0,05 bis 10 Gew.%, insbesondere 0,2 bis 5 Gew.% an Photopolymerisationsinitiatoren, 2 bis 50 Gew.%, vorzugsweise 5 bis 30 Gew.% an abräsiven Partikeln sowie gegebenenfalls aus weiteren üblichen Hilfs- und Zusatzstoffen in üblichen und bekannten Mengen, wobei sich die angegebenen Gewichtsprozente jeweils auf das die abräsiven Partikel enthaltende photopolymerisierbare und/oder photovernetzbare Material beziehen.

In dem Fall, in dem die photopolymerisierbare und/oder photovernetzbare Schicht (S) der lichtempfindlichen Aufzeichnungsmaterialien die abräsiven Partikel nur in einer dünnen Oberflächenzone enthält, wohingegen der übrige Teil der photopolymerisierbaren und/oder photovernetzbaren Schicht (S) keine abräsiven Partikel enthält, die photopolymerisierbare und/oder photovernetzbare Schicht (S) somit aus mehreren Lagen besteht, ist es möglich, daß die einzelnen Lagen der photopolymerisierbaren und/oder photovernetzbaren Schicht (S) mit Ausnahme der abräsiven Partikel aus den sonst gleichen photopolymerisierbaren und/oder photovernetzbaren Materialien bestehen. Es ist aber ebenso möglich, daß sich die photopolymerisierbaren und/oder photovernetzbaren Materialien dieser Lagen auch bezüglich der anderen Bestandteile, wie z. B. Art und Menge des Basispolymeren, Art und Menge der photopolymerisierbaren olefinisch ungesättigten niedermolekularen Verbindungen oder Art und Menge der Photopolymerisationsinitiatoren unterscheiden. So ist es beispielsweise besonders günstig, wenn eine mehrlagige Schicht (S) in der die abräsiven Partikel enthaltenden Lage als Photopolymerisationsinitiator ein Gemisch aus einem niedrig absorbierenden und einem stark absorbierenden Initiator enthält, wie sie weiter oben bereits beschrieben worden sind, während die von den abräsiven Partikeln freie Lage der Schicht (S) nur einen oder mehrere niedrig absorbierende Initiatoren enthält. Vorzugsweise sind bei einer mehrlagigen Schicht (S) die Polymeren und photopolymerisierbaren niedermolekularen Verbindungen in den photopolymerisierbaren und/oder photovernetzbaren Materialien der einzelnen Lagen gleich oder zumindest ähnlich und miteinander verträglich.

Der dimensionsstabile Träger für die photopolymerisierbare und/oder photovernetzbare Schicht (S) kann einerseits der eigentliche Druckformträger sein, es kann sich hierbei aber auch um einen temporären Träger handeln, der z. B. zur Lagerung und zum Transport der photopolymerisierbaren und/oder photovernetzbaren Schicht (S) dient und der dann nach Aufbringen der Schicht (S) auf den eigentlichen Druckformträger von der Schicht (S) abgezogen und entfernt wird. Bei den Druckformträgern handelt es sich im allgemeinen entweder um einen Stahlzylinder oder um ein plattenförmiges Stahlblech. Zur Erzielung einer guten Haftung zwischen der photopolymerisierbaren und/oder photovernetzbaren Schicht (S) und dem Druckformträger ist es oft zweckmäßig, den Druckformträger vor dem Aufbringen der Schicht (S) mit einer dünnen Schicht eines Haftvermittlers, beispielsweise auf Basis von Polyurethan-Reaktionslacken, Phenolharzen und/oder Epoxidharzen, zu versehen. Als Material für den temporären Träger kommen insbesondere dimensionsstabile Kunststoffolien einer Dicke im allgemeinen im Bereich von 50 bis 250 μm, insbesondere von 75 bis 150 μm in Betracht. Vorzugsweise besteht der temporäre Träger aus einer Polyester-Folie, insbesondere aus Polyethylenterephthalat oder Polybutylenterephthalat.

Die Herstellung der erfindungsgemäßen lichtempfindlichen Aufzeichnungsmaterialien erfolgt üblicherweise derart, daß zunächst die Bestandteile der photopolymerisierbaren und/oder photovernetzbaren Materialien innig miteinander vermischt werden und diese Mischung dann in Form der Schicht (S) auf den dimensionsstabilen Träger aufgebracht wird. Das Mischen der Bestandteile der photopolymerisierbaren und/oder photovernetzbaren Materialien kann dabei in an sich bekannter Weise in Lösung, einem Kneter oder jeder anderen Mischvorrichtung vorgenommen werden, die geeignet ist, eine innige Mischung und möglichst homogene Verteilung der einzelnen Bestandteile zu bewirken. Liegt die erhaltene Mischung in fester Form vor, kann anschließend die Schicht (S) durch Extrudieren, Kalandrieren oder Pressen des photopolymerisierbaren und/oder photovernetzbaren Materials geformt werden entweder unter gleichzeitigem oder anschließendem Auflaminieren oder Aufkaschieren auf den dimensionsstabilen Träger. Um in einfacher Weise die gewünschte glatte Oberfläche der Schicht (S) mit einer Rauhtiefe von < 2 μm, vorzugsweise von < 1 μm, zu erlangen, wird die Schicht (S) bevorzugt durch Gießen von einer Lösung des photopolymerisierbaren und/oder photovernetzbaren Materials auf den dimensionsstabilen Träger hergestellt. In diesem Fall wird selbstverständlich zweckmäßigerweise auch bereits das Mischen der Bestandteile des photopolymerisierbaren und/oder photovernetzbaren Materials in Lösung durchgeführt. Als Lösungsmittel für die Gießlösungen, dessen Wahl auch von der Art und Zusammensetzung des photopolymerisierbaren und/oder photovernetzbaren Materials abhängt, kommen die hierfür üblichen und bekannten Lösungsmittel in Betracht, wie beispielsweise Alkohole, Ether, Ester, Ketone, aliphatische halogenierte Kohlenwasserstoffe, aromatische Kohlenwasserstoffe etc.

Für die lichtempfindlichen Aufzeichnungsmaterialien, bei denen die gesamte Schicht (S) die abräsiven Partikel enthält, d. h. also bei einlagigen Schichten (S), kann das Aufbringen der Schicht (S) auf den dimensionsstabilen Träger aus der Lösung in einem Arbeitsgang erfolgen. Für die Herstellung einer mehrlagigen Schicht (S), bei der die abräsiven Partikel nur in einer Oberflächenzone der Schicht (S) vorhanden sind, werden die Lage mit den abräsiven Partikeln und die Lage ohne die abräsiven Partikel in getrennten Schritten nacheinander erzeugt.

Wird die Schicht (S) direkt auf dem Druckformträger durch Gießen, Sprühen oder Aufrakeln einer Lösung des photopolymerisierbaren und/oder photovernetzbaren Materials erzeugt, so wird — für die Herstellung einer mehrlagigen Schicht (S) — zunächst die Lösung des photopolymerisierbaren und/oder photovernetzbaren Materials, das keine abräsiven Partikel enthält, aufgebracht. Nach Verdunsten des Lösungsmittels wird darauf anschließend die Lösung des photopolymerisierbaren und/oder photovernetzbaren Materials, das die abräsiven Partikel enthält, aufgetragen. Zur Herstellung von einlagigen Schichten (S) wird die Lösung des die abräsiven Partikel enthaltenden photopolymerisierbaren und/oder photovernetzbaren Materials direkt auf den gegebenenfalls mit einer Haftschicht versehenen Druckformträger aufgebracht. Das Aufbringen der Lösungen auf einen zylinderförmigen Druckformträger erfolgt dabei vorzugsweise mittels der an sich bekannten Ringbeschichtungsanlagen; bei plattenförmigen Druckformträgern kann das Aufbringen der Lösungen insbesondere nach den bekannten Gieß- oder Sprühverfahren vorgenommen werden. Das Aufbringen der Lösungen von abräsive Partikel enthaltenden photopolymerisierbaren und/oder photovernetzbaren Materialien auf Druckformträger erfolgt dabei am besten durch Beschichten mittels eines Beschichtungsmessers, um nach dem Verdunsten des Lösungsmittels zu einer möglichst glatten Oberfläche der Schicht (S) zu gelangen. Erforderlichenfalls kann bei dieser Art der Herstellung der lichtempfindlichen Aufzeichnungsmaterialien, insbesondere bei Einsatz von zylinderförmigen Druckformträgern, zur Erzielung einer sehr glatten Oberfläche der Schicht (S) auf die die abräsiven Partikel enthaltende Lage der Schicht (S) noch eine sehr dünne, maximal 5 μm dicke, vorzugsweise 1 bis 3 μm dicke weitere Lage aus einem photopolymerisierbaren und/oder photovernetzbaren Material, welches frei von abräsiven Partikeln ist, aufgebracht werden.

Diese äußere dünne Lage der Schicht (S) wird vorzugsweise aus dem gleichen photopolymerisierbaren und/oder photovernetzbaren Material gebildet wie die darunterliegende, die abräsiven Partikel enthaltende Lage, selbstverständlich mit Ausnahme der abräsiven Partikel. Es hat sich gezeigt, daß trotz einer solchen dünnen, maximal nur einige μm dicken äußeren Lage ohne abräsive Partikel die Qualität, insbesondere Abriebs- und Kratzfestigkeit, sowie die Verwendbarkeit der aus solchen Aufzeichnungsmaterialien hergestellten Tiefdruckformen nicht beeinträchtigt ist.

Vorteilhafterweise wird die photopolymerisierbare und/oder photovernetzbare Schicht (S) zunächst auf einen temporären Träger, insbesondere eine Polyester-Folie, aufgebracht und anschließend — entweder vor oder nach der Belichtung — auf den eigentlichen Druckformträger aufkaschiert. Diese Verfahrensweise hat sich insbesondere bei Einsatz von plattenförmigen Druckformträgern für die Herstellung von Druckplatten als günstig erwiesen. Hierbei wird in aller Regel die dem temporären Träger abgewandte Oberfläche der Schicht (S) auf den Druckformträger aufgebracht, so daß die dem temporären Träger zugewandte Oberfläche der Schicht (S) nachher die eigentliche Oberfläche der Druckform bildet. Zur Herstellung einer mehrlagigen Schicht (S) auf einem temporären Träger wird zunächst die Lösung des die abräsiven Partikel enthaltenden photopolymerisierbaren und/oder photovernetzbaren Materials auf den temporären Träger in an sich bekannter Art, z. B. durch Gießen, Schleudern, Spritzen oder Aufrakeln aufgebracht und das Lösungsmittel verdunstet. Auf diese erste Lage der Schicht (S) wird danach in gleicher Weise die Lösung des photopolymerisierbaren und/oder photovernetzbaren Materials aufgetragen, welches keine abräsiven Partikel enthält. Die Oberfläche des temporären Trägers, vorzugsweise einer Polyester-Folie, auf der die Lösung des die abräsiven Partikel enthaltenden photopolymerisierbaren und/oder photovernetzbaren Materials aufgebracht wird, soll möglichst glatt sein und insbesondere eine Rauhtiefe von weniger als 2 μm, vorzugsweise von weniger als 1 μm besitzen. Dies gilt gleichermaßen für die Herstellung von einlagigen oder mehrlagigen Schichten (S). Damit wird in einfacher Weise erreicht, daß die Oberfläche der Schicht (S), die die spätere Oberfläche der Druckschicht darstellt, trotz des Gehaltes an abräsiven Partikeln die gewünschte Glätte und geringe Rauhtiefe aufweist.

Gegebenenfalls kann auf der Oberfläche der photopolymerisierbaren und/oder photovernetzbaren Schicht (S), die die spätere Oberfläche der eigentlichen Druckschicht der Tiefdruckform darstellt, noch eine dünne, bis etwa 5 μm dicke, vorzugsweise 1 bis 4 μm dicke, Schicht aufgebracht sein, die für aktinisches Licht durchlässig ist, die aber die Sauerstoffdiffusion in die photopolymerisierbare und/oder photovernetzbare Schicht (S) hemmt und somit eine Sauerstoffinhibierung der Photopolymerisation bei der Belichtung der erfindungsgemäßen lichtempfindlichen Aufzeichnungsmaterialien verhindert. Derartige Sauerstoff-Sperrschichten sind bei lichtempfindlichen Aufzeichnungsmaterialien für die Herstellung von Hochdruckformen oder Photoresists an sich bekannt und können im Fall der erfindungsgemäßen Aufzeichnungsmaterialien für die Herstellung von abriebs- und kratzfesten Tiefdruckformen aus den für die Sauerstoff-Sperrschichten üblichen und gebräuchlichen Materialien, insbesondere Kunststoffen, bestehen. Die Sauerstoff-Sperrschicht muß in dem Entwicklerlösungsmittel für die photopolymerisierbare und/oder photovernetzbare Schicht (S) löslich sein und wird nach dem Belichten der Aufzeichnungsmaterialien zusammen mit den unbelichteten Bereichen der Schicht (S) abgewaschen.

Die photopolymerisierbaren und/oder photovernetzbaren Materialien für die Schicht (S) der erfindungsgemäßen lichtempfindlichen Aufzeichnungsmaterialien sollen so ausgewählt werden, daß die Druckschicht der daraus hergestellten Tiefdruckformen mindestens in dem die farbaufnehmenden Vertiefungen enthaltenden Schichtdickenbereich eine unter Last gemessene Vickers-Härte von mindestens 10 N/mm$^2$ hat. Im allgemeinen wird die Druckschicht über die gesamte Schichtdicke eine einheitliche Härte haben. Es ist aber auch möglich und hinreichend, wenn die Druckschicht nur in einem Oberflächenbereich bis zu einer Schichttiefe, die der Tiefe der farbaufnehmenden Näpfchen entspricht, die geforderte Härte aufweist, wobei die darunter liegenden Bereiche der Druckschicht beispielsweise weichelastisch ausgebildet sein können. Die Härte der Druckschicht wird dabei weniger durch Art und Menge der abräsiven Partikel beeinflußt; vielmehr hängt sie von dem in den photopolymerisierbaren und/der photovernetzbaren Materialien eingesetzten Basispolymeren und dem Vernetzungsgrad bei der Photopolymerisation, d. h. von Art und Menge der Monomeren sowie von dem eingesetzten Photoinitiator ab. Wie das photopolymerisierbare und/oder photovernetzbare Material unter Berücksichtigung der hierzu oben gemachten Ausführungen beschaffen sein muß, damit es nach der Belichtung die gewünschte Härte besitzt, ist für den Fachmann durch wenige Vorversuche leicht zu ermitteln. Die Härte der Druckschicht oder auch von Schichtbereichen der Druckschicht, insbesondere dem Oberflächenbereich, kann gegebenenfalls durch Nachbehandlungsschritte bei der belichteten und entwickelten Druckform — wie nachfolgend näher beschrieben — variiert und noch vergrößert werden.

Die Auswahl der Materialien, insbesondere die Wahl des Basispolymeren für die photopolymerisierbaren und/oder photovernetzbaren Materialien wird auch durch den Anwendungsbereich der Tiefdruckformen insoweit mitbestimmt, als die Druckschicht gegenüber den für die Druckfarben verwendeten Lösungsmitteln resistent sein muß. Die am meisten verwendeten Lösungsmittel in Tiefdruckfarben sind Toluol und in geringerem Maße auch Benzin, d. h. niedrig siedende aliphatische Kohlenwasserstoffe. Daneben kommen jedoch auch alkohol-, ester-, keton- oder wasserhaltige Tiefdruckfarben zum Einsatz. Da die photopolymeren Druckschichten nicht gegen alle Lösungsmittel gleichermaßen resistent sind, hängt die Wahl des Basispolymeren in den photopolymerisierbaren und/oder photovernetzbaren Materialien auch von dem beim Tiefdruck zur Anwendung kommenden Druckfarbenlösungsmittel ab. Für die am meisten verbreitetsten Druckfarben auf Basis von Toluol oder Benzin als Lösungsmittel haben sich für die Herstellung der Tiefdruckformen insbesondere solche Materialien bewährt, die in der Schicht (S) als Basis-Polymer ein Polyamid oder Mischpolyamid bzw. ein Vinylalkoholpolymerisat oder teilverseiftes Vinylester-Polymerisat enthalten.

Zur Herstellung der Tiefdruckformen werden die erfindungsgemäßen lichtempfindlichen Aufzeichnungsmaterialien durch eine geeignete Bildvorlage mit aktinischem Licht bestrahlt, wodurch die belichteten Bereiche der Schicht (S) photopolymerisieren und -vernetzen und so in der Entwicklerflüssigkeit unlöslich werden, während die umbelichteten Bereiche löslich bleiben und mit der Entwicklerflüssigkeit ausgewaschen werden können.

Wenn die photopolymerisierbare und/oder photovernetzbare Schicht (S) auf einem temporären Träger aufgebracht ist, so kann die Schicht (S) noch vor der Belichtung auf den Druckformträger aufkaschiert und anschließend belichtet werden. Die Belichtung kann danach wahlweise erfolgen, nachdem der temporäre Träger von der Schicht (S) abgezogen worden ist, oder durch den temporären Träger hindurch, wobei dieser dann erst nach der Belichtung abgezogen wird. Andererseits ist es auch möglich, die auf dem temporären Träger befindliche photopolymerisierbare und/oder photovernetzbare Schicht (S) bereits vor dem Aufkaschieren auf den Druckformträger zu belichten.

Zum Belichten der lichtempfindlichen Aufzeichnungsmaterialien werden Lichtquellen eingesetzt, die aktinisches Licht im Wellenlängenbereich von im allgemeinen 250 bis 700 nm, vorzugsweise im Bereich von 300 bis 500 nm auszustrahlen vermögen und deren Emissionsmaxima im allgemeinen im Bereich der Absorption der Photoinitiatoren liegen. Für die erfindungsgemäße Herstellung der Tiefdruckformen können die in der Reproduktionstechnik üblichen Lichtquellen, wie Kohlebogenlampen, aktinische oder superaktinische Leuchtstoffröhren, Quecksilber-Nieder-, -Mittel und -Hochdruckstrahler, die gegebenenfalls dotiert sein können, sowie Xenonlampen oder Laser mit hohem UV-Anteil, z. B. Argon-Ionen-Laser mit UV-Ausgangsleistungen von 1 bis 2 Watt, verwendet werden. Der Belichtungsvorgang kann dabei in üblichen und gebräuchlichen Kontaktkopierrahmen (bei Platten oder Folien) oder auf handelsüblichen Rundbelichtungsgeräten (bei Zylindern) durchgeführt werden. Als Bildvorlage für die Belichtung können die üblichen Raster- oder Strich-Positive verwendet werden oder auch Halton-Positive in Kombination mit Führungsraster-Vorlagen.

Die genaue Belichtungzeit hängt von der Art des für die photopolymerisierbare und/oder photovernetzbare Schicht (S) verwendeten Materials ab. Sie liegt üblicherweise im Bereich von 0,5 bis 10 Minuten und läßt sich für das verwendete Schichtmaterial durch wenige Vorversuche leicht ermitteln. Die Belichtungszeit soll dabei insbesondere so lang sein, daß die die abrasiven Partikel enthaltende Oberflächenzone der Schicht (S) vollständig durchpolymerisiert und vernetzt ist und beim anschließenden Auswaschvorgang von der Entwicklerflüssigkeit nicht mehr angegriffen wird. Das Auswaschen bzw. Entwickeln der bildmäßig belichteten Aufzeichnungsmaterialien zur Entfernung der unbelichteten und somit noch löslichen Schichtteile unter Ausbildung der Raster- und Näpfchenstruktur der Tiefdruckformen erfolgt in an sich bekannter und üblicher Weise durch Behandeln der bildmäßig belichteten Aufzeichnungsmaterialien mit der Entwicklerflüssigkeit, z. B. in einem Entwicklerflüssigkeitsbad, einem Sprühwascher oder Bürstenwascher oder auf sonst geeignete andere Weise.

Als Entwicklerflüssigkeiten bzw. Auswaschlösungsmittel kommen ausgewählt solche Lösungsmittel bzw. Lösungsmittelgemische in Frage, in welchen das unbelichtete photopolymerisierbare und/oder photovernetzbare Material gut löslich bzw. zumindest leicht dispergierbar ist, während die photopolymerisierten Materialien nach der Belichtung darin unlöslich bzw. nicht mehr dispergierbar sind. Die Wahl der geeigneten Entwicklerflüssigkeiten hängt von der Zusammensetzung des photopolymerisierbaren und/oder photovernetzbaren Materials, insbesondere von der Art des darin enthaltenen Polymeren ab. Vorzugsweise werden solche Entwicklerflüssigkeiten gewählt, die umwelt- und arbeitsfreundlich sind, d. h. die ohne besondere Vorsichtsmaßnahmen gehandhabt werden können und die einfach und leicht zu reinigen und aufzubereiten sind. Beispiele von Entwicklerflüssigkeiten sind niedere aliphatische Alkohole, Gemische von Alkoholen mit Wasser, Glykolether, Glykolester, wäßrige oder alkoholische Alkalilauge, verdünnte wäßrige Säure oder auch Wasser selber. Für photopolymerisierbare und/oder photovernetzbare Materialien auf Basis von Vinylalkoholpolymerisaten oder ungesättigten Polyesterharzen sind beispielsweise Wasser oder wäßrig-alkalische Lösungen als Entwicklerflüssigkeit geeignet ; bei photopolymerisierbaren und/oder photovernetzbaren Materialien auf Basis von Mischpolyamiden haben sich als Entwicklerflüssigkeiten niedere aliphatische Alkohole, insbesondere Gemische von solchen Alkoholen mit Wasser, beispielsweise Mischungen aus Ethanol mit Wasser im Verhältnis 8 : 2 bewährt.

Das Behandeln der belichteten Tiefdruckformen mit Entwicklerflüssigkeit, d. h. den Vorgang des Auswaschens unbelichteter Teile, wird man bevorzugt bei Temperaturen durchführen, bei denen der Auswaschprozeß in einem möglichst kurzen Zeitraum, d. h. etwa innerhalb von 1 bis 10 Minuten beendet ist, ohne daß dabei jedoch die belichteten Bereiche der photopolymeren Tiefdruckformen durch die Entwicklerflüssigkeit angegriffen werden. Für die meisten Entwicklerflüssigkeiten sind Auswaschtemperaturen zwischen 10 °C und 40 °C vorteilhaft. Auch wenn als Entwicklerflüssigkeiten bevorzugt solche Lösungsmittel oder Lösungsmittelgemische gewählt werden, die die belichteten, unlöslichen Schichtteile möglichst wenig oder gar nicht angreifen, diffundieren im allgemeinen die Entwicklerflüssigkeiten auch in die unlöslichen Schichtteile des photopolymerisierten Materials ein, so daß es ratsam ist, diese Lösungsmittelreste durch einen kurzzeitigen Trocknungsprozeß anschließend an den Auswaschvorgang zu entfernen. Die Trocknung kann bei Raumtemperatur oder auch bei höheren Temperaturen, beispielsweise im Bereich von 50 °C bis 120 °C, erfolgen und wird durch einen wirksamen Luftwechsel, z. B. durch ein Gebläse, einen Ventilator oder ähnliches, gefördert. Die Trocknung bei erhöhter Temperatur bringt zusätzlich den Vorteil, daß hierdurch gegebenenfalls auch noch die Härte der Druckschicht erhöht werden kann.

In einigen Fällen, besonders bei den Tiefdruckformen, deren Druckschicht als Basispolymere Polyamide, Mischpolyamide oder Vinylalkoholpolymerisate enthalten, hat es sich als vorteilhaft herausgestellt, wenn die Tiefdruckformen nach der Trocknung durch kurzzeitiges Erwärmen auf Temperaturen im Bereich von 200 °C bis etwa 260 °C, vorzugsweise auf Temperaturen von 220 bis 240 °C einer zusätzlichen Härtung unterzogen wird. Für diese Nachhärtung bei hohen Temperaturen sind im allgemeinen Zeiten von 5 bis 60 Minuten ausreichend ; es sind jedoch auch längere Zeiten für die Nachhärtung möglich. Bei diesem nachträglichen Härten wird die photopolymere Schicht eingebrannt, wobei ihre unter Last gemessene Vickers-Härte auf Werte über 200 N/mm² ansteigt. Eine gleichzeitige Verfärbung der Schicht nach hell- bis dunkelbraunen Farbtönen ist dabei sowohl bezüglich ihrer mechanischen als auch bezüglich ihrer drucktechnischen Eigenschaften unschädlich.

Ferner hat es sich in einigen Fällen als vorteilhaft erwiesen, die erfindungsgemäß hergestellte Tiefdruckform nach dem Auswaschen und Trocknen vollflächig nachzubelichten. Diese Nachbelichtung, bei der die Photopolymerisation und/oder Photovernetzung in der Druckschicht vervollständigt wird, ist insbesondere dann empfehlenswert, wenn bei der Herstellung der Tiefdruckformen von lichtempfindlichen Aufzeichnungsmaterialien ausgegangen wird, die in der photopolymerisierbaren und/oder photovernetzbaren Schicht (S) stark lichtabsorbierende Photoinitiatoren, wie beispielsweise Michlers Keton oder Derivate von Michlers Keton, enthalten. Die erfindungsgemäß hergestellten Tiefdruckformen lassen sich weiterhin derart ausgestalten, daß die photopolymere Druckschicht nicht unmittelbar auf dem Druckformträger aufgebracht ist, sondern mit diesem über eine oder mehrere Unterschichten haftfest verbunden ist. Solche Unterschichten bestehen im allgemeinen aus Kunststoffmaterial, das nicht photopolymerisierbar und/oder photovernetzbar ist, mit der Schicht (S) sowie dem Druckformträger haftfest verbunden werden kann, sowie in den Entwicklerflüssigkeiten unlöslich ist. Für diese Unterschichten lassen sich die gleichen, oder chemisch ähnliche Materialien verwenden, wie für die photopolymerisierbare und/oder photovernetzbare Schicht (S). Es kann dabei von Nutzen sein, insbesondere bei Spitzenbelastungen der Tiefdruckformen, aber auch bei Tiefdruckformen mit hohen langwelligen Oberflächentoleranzen, die Unterschicht als weichelastische Schicht auszubilden.

Die erfindungsgemäß hergestellten Tiefdruckformen eignen sich für den Einsatz in den konventionellen Tiefdruckmaschinen und liefern Druckergebnisse, die je nach der angewandten Technik und der Art des verwendeten photopolymerisierbaren und/oder photovernetzbaren Materials mit den Resultaten, die von herkömmlichen Tiefdruckformen erzielt werden, identisch sind. Ein wesentlicher Vorteil der erfindungsgemäß hergestellten Tiefdruckformen gegenüber den konventionellen Tiefdruckformen mit einer Ballard-Haut liegt in ihrer einfachen und schnellen Herstellmethode, ohne daß dabei die konventionellen Tiefdruckformen drucktechnische Vorteile aufweisen. Insbesondere zeichnen sich die erfindungsgemäß hergestellten Tiefdruckformen, gerade im Vergleich zu den bekannten Tiefdruckformen mit Kunststoffdruckschichten, durch ihre hohe Abriebs- und Kratzfestigkeit aus, so daß es möglich ist, mit den erfindungsgemäß hergestellten Tiefdruckformen Auflagenhöhen von 500 000 bis 1 000 000 bei gleichbleibend guter Druckqualität, insbesondere auch hinsichtlich der Halbtonwidergabe, zu erreichen. Besonders hervorzuheben ist ferner, daß beim Tiefdruck mit den erfindungsgemäß hergestellten Tiefdruckformen im Gegensatz zu den bisher bekannten Tiefdruckformen mit Kunststoff-Druckschichten die herkömmlichen gebräuchlichen Stahlrakeln verwendet werden können, ohne daß hierdurch die Druckschicht oder die Stahlrakeln in irgendeiner Weise beschädigt werden. Die Stahlrakeln schleifen sich bei Einsatz der erfindungsgemäß hergestellten Tiefdruckformen in gleicher Weise wie bei den konventionellen Tiefdruckformen mit Ballard-Haut gleichmäßig an der Oberfläche der photopolymeren Druckschicht ab. Als besonders vorteilhaft haben sich beim Tiefdruck mit den erfindungsgemäß hergestellten Tiefdruckformen biegeelastische Stahlrakeln mit abgerundeten Fasenkanten und einer Oberflächenhärte von mindestens 350 (Vickers-Härte nach DIN 50 133) erwiesen, wie sie in der DE-A 31 10 842 beschrieben sind. Sofern die erfindungsgemäß hergestellten Tiefdruck- formen bei ihrer Verwendung, beispielsweise durch fehlerhafte Rakeln oder dergleichen, beschädigt werden und Kratzer, Rillen oder Riefen aufweisen, lassen sie sich in gleicher Weise wie die herkömmlichen Tiefdruckformen mit einer Ballard-Haut glatt polieren. Durch diese besondere, vorteilhafte Eigenschaft, die in keiner Weise zu erwarten stand, läßt sich die Verwendbarkeit der erfindungsgemäßen Tiefdruckformen nochmals erheblich verlängern.

Die Erfindung wird durch die nachfolgenden Beispiele erläutert. Die in den Beispielen angegebenen Teile beziehen sich, sofern nicht anders angegeben, auf das Gewicht. Die im Rahmen dieser Erfindung angegebenen Werte für die Rauhtiefe sind bestimmt nach DIN 4762. Die Methode zur Ermittlung der unter Last gemessenen Vickers-Härte ist beschrieben in Kunststoffe, Bd. 60 (1970), Seiten 265 bis 273. Es handelt sich hierbei um eine Anpassung der in DIN 50 133 festgelegten Härteprüfung nach Vickers für die Härtebestimmung von Kunststoffen.

Beispiel 1

Auf ein mit einer Haftschicht aus Polyurethan versehenes, 240 µm starkes Stahlblech wurde eine 200 µm dicke photopolymerisierbare Schicht folgender Zusammensetzung aufgebracht :
54 Teile eines in wäßrigem Alkohol löslichen Mischpolyamids aus etwa gleichen Teilen Hexamethylendiamin-Adipat, 4,4′-Diamino-dicyclohexylmethan-adipat und ε-Caprolactam, 24 Teile des Diethers aus 1 Mol Ethylenglykol und 2 Mol N-Methylolacrylamid, 2 Teile Benzildimethylketal sowie 20 Teile Quarzmehl (Typ F 600 der Fa. Quarzwerke Frechen). Dabei lagen die Schichtbestandteile in inniger Mischung vor. Die photopolymerisierbare Schicht wurde durch eine autotypische Tiefdruckvorlage belichtet. Die noch löslichen Anteile der photopolymerisierbaren Schicht wurden mit Ethanol/Wasser-Gemisch herausgewaschen und die so erhaltene Tiefdruckform bei 80 °C 30 Minuten lang getrocknet. Die unter Last gemessene Vickers-Härte betrug 15 N/mm².
Die Druckform wurde in einem Abriebtester des Typs AT II der Firma Burda geprüft. Nach einer Million Rakeldurchgängen war die Druckform vollkommen unbeschädigt ; die Rakel zeigte einen geringen, gleichmäßigen Abrieb. Des weiteren wurde mit einer so hergestellten Druckform in einer Tiefdruckrotation gedruckt. Nach 500 000 Zylinderumdrehungen war die Druckform noch unbeschädigt. Die erhaltenen Druckbilder waren von einwandfreier Qualität.

Vergleichsbeispiel A

Analog Beispiel 1 wurde eine Tiefdruckform hergestellt, jedoch bestand die photopolymerisierbare Schicht vor der Belichtung aus einer innigen Mischungen folgender Zusammensetzung :

68 Teile des in Beispiel 1 verwendeten Mischpolyamids, 30 Teile des Diethers aus 1 Mol Ethylenglykol und 2 Mol N-Methylolacrylamid sowie 2 Teilen Benzildimethylketal. Belichtung, Auswaschen und Trocknen der Tiefdruckform erfolgte wie in Beispiel 1. Die unter Last gemessene Vickers-Härte der Druckform betrug 15 N/mm². Die Druckform wurde in dem Abriebtester des Typs AT II der Fa. Burda geprüft. Nach 50 000 Rakeldurchgängen zeigte die Druckform tiefe Kratzer und eine Abnahme des Näpfchen-Volumens. Die Rakel war stark beschädigt. Beim Drucktest mit dieser Druckform in einer Druckmaschine (Fa. Albert, Frankenthal) zeigten sich nach 45 000 Zylinderumdrehungen Streifen im Druckbild ; nach 40 000 Zylinderumdrehungen konnte eine deutliche Abnahme der Tondichte aufgrund des verringerten Näpfchen-Volumens festgestellt werden.

Vergleichsbeispiel B

Eine Tiefdruckform wurde analog Beispiel 1 hergestellt, jedoch enthielt die photopolymerisierbare Schicht anstelle des Quarzmehls 20 Teile feines Talkum-Pulver. Bei der Prüfung der Tiefdruckform in dem Abriebtester des Typs AT II waren nach 50 000 Rakeldurchgängen sowohl die Druckform als auch die Rakel stark beschädigt.

Beispiel 2

Zur Herstellung einer Tiefdruckform wurde auf ein mit einer Haftschicht aus Polyurethanen versehenes, 240 µm starkes Stahlblech eine 200 µm dicke, photopolymerisierbare Schicht folgender Zusammensetzung aufgebracht : 48 Teile eines teilverseiften Polyvinylacetats (Verseifungsgrad 82 Mol.%, Polymerisationsgrad 500), 30 Teile Hydroxyethylmethacrylat, 2 Teile Benzildimethylketal und 20 Teile Quarzmehl (Typ F 600 der Fa. Quarzwerke Frechen). Die photopolymerisierbare Schicht wurde durch eine autotypische Tiefdruckvorlage belichtet. Die noch löslichen Anteile der Schicht wurden anschließend mit Wasser herausgelöst und die so erhaltene Tiefdruckform 30 Minuten bei 80 °C getrocknet. Die unter Last gemessene Vickers-Härte der Druckform betrug 40 N/mm².
Die Druckform wurde in einem Abriebtester des Typs AT II der Fa. Burda geprüft. Nach einer Million Rakeldurchgängen war die Druckform vollkommen unbeschädigt. Die Rakel zeigte einen geringen gleichmäßigen Abrieb.

Vergleichsbeispiel C

Es wurde eine Tiefdruckform, wie in Beispiel 2 beschrieben, hergestellt, jedoch hatte die photopolymerisierbare Schicht folgende Zusammensetzung :
60 Teile eines teilverseiften Polyvinylacetats (Verseifungsgrad 82 Mol.%, Polymerisationsgrad 500), 38 Teile Hydroxyethylmethacrylat, 2 Teile Benzildimethylketal. Belichten, Auswaschen und Trocknen der Tiefdruckform erfolgte wie in Beispiel 2. Die Druckform wurde in einem Abriebtester des Typs AT II geprüft. Nach ca. 50 000 Rakeldurchgängen zeigte die Druckform tiefe Kratzer und eine deutliche Abnahme des Näpfchen-Volumens. Die Rakel war sehr ungleichmäßig abgenutzt.

## Beispiel 3

Eine Tiefdruckform wurde wie in Beispiel 1 hergestellt, jedoch wurde die Druckform nach dem Trocknen zusätzlich 15 Minuten bei 120 °C unter gleichzeitiger Bestrahlung mit UV-Licht behandelt und danach 10 Minuten bei 250 °C gehärtet. Die Druckform hatte danach eine unter Last gemessene Vickers-Härte von 200 N/mm$^2$. Nach einer Million Rakeldurchgängen in einem Abriebtester des Typs AT II war die Druckform völlig unbeschädigt. Bei einem Drucktest wurden ausgezeichnete Druckergebnisse erhalten.

## Beispiel 4

Eine Tiefdruckform wurde analog Beispiel 2 hergestellt, jedoch nach dem Trocknen zusätzlich 15 Minuten lang bei 120 °C unter gleichzeitiger UV-Bestrahlung behandelt und anschließend 10 Minuten bei 250 °C nachgehärtet. Die Druckform hatte eine unter Last gemessene Vickers-Härte von 250 N/mm$^2$. Nach einer Million Rakeldurchgängen in einem Abriebtester AT II war die Druckform ohne erkennbare Schäden und lieferte einwandfreie Druckergebnisse.

## Beispiel 5

Auf ein mit einer Haftschicht aus Polyurethanen versehenes, 240 μm starkes Stahlblech wurde eine 200 μm dicke photovernetzbare Schicht folgender Zusammensetzung aufgebracht :
54 Teile des in Beispiel 1 beschriebenen Polyamids, 24 Teile des Diethers aus 1 Mol Ethylenglykol und 2 Mol N-Methylolacrylamid, 2 Teile Benzildimethylketal, 0,2 Teile Michlers Keton und 20 Teile Quarzmehl (Typ F 600 der Fa. Quarzwerke Frechen). Dieses lichtempfindliche Material wurde, wie in Beispiel 1 beschrieben, belichtet, ausgewaschen und getrocknet. Die erhaltene Tiefdruckform zeigte dabei eine größere Resistenz gegenüber der alkoholischen Auswaschlösung und hatte einen stärkeren Oberflächenglanz als die gemäß Beispiel 1 herstellte Druckform.

## Beispiel 6

Es wurde analog Beispiel 1 eine Tiefdruckform hergestellt, jedoch hatte die photopolymerisierbare Schicht vor der Belichtung folgende Zusammensetzung :
65 Teile des in Beispiel 1 beschriebenen Polyamids, 28 Teile des Diethers aus einem Mol Ethylenglykol und 2 Mol N-Methylolacrylamid, 2 Teile Benzildimethylketal und 5 Teile des in Beispiel 1 beschriebenen Quarzmehls. Die so erhaltene Tiefdruckform war nach einer Million Rakeldurchgänge im Abriebtester des Typs AT II der Fa. Burda völlig unbeschädigt.

## Beispiel 7

Es wurde eine Tiefdruckform analog Beispiel 5 hergestellt, jedoch anstelle der 20 Teile Quarzmehl wurden diesmal 20 Teile Kristabolitmehl (Fa. Quarzwerke Frechen) eingesetzt. Die Druckform hatte eine glänzende Oberfläche und war nach einer Million Rakeldurchgänge im Abriebtester des Typs AT II unbeschädigt.

## Beispiel 8

Eine Lösung von 100 Teilen des in Beispiel 1 beschriebenen photopolymerisierbaren Materials, welches jedoch diesmal anstelle des Quarzmehls 20 Teile Aluminiumoxid enthielt, in 50 Teilen Methanol wurde auf 125 μm dicke Polyesterfolie in einer solchen Dicke gegossen, daß nach dem Abdampfen des Lösungsmittels die photopolymerisierbare Schicht eine Dicke von 50 μm besaß. Anschließend wurden die photopolymerisierbare Schicht auf ein mit einer Haftschicht aus Polyurethanen versehenes Stahlblech kaschiert, die Polyesterfolie von der photopolymerisierbaren Schicht abgezogen und zur Herstellung einer Tiefdruckform wie in Beispiel 1 beschrieben, durch eine autotypische Bildvorlage belichtet, ausgewaschen und getrocknet. Bei der Prüfung in dem Abriebtester des Typs AT II der Fa. Burda waren nach 500 000 Rakeldurchgängen keinerlei Beschädigungen an der Druckform oder der Rakel festzustellen.

## Ansprüche

1. Lichtempfindliches Aufzeichnungsmaterial für die Herstellung von Tiefdruckformen mit einer auf einem dimensionsstabilen Träger aufgebrachten 30 bis 500 μm dicken Schicht (S) eines in einer Entwicklerflüssigkeit löslichen bzw. dispergierbaren und durch Belichtung mit aktinischem Licht in dieser Entwicklerflüssigkeit unlöslich bzw. nicht mehr dispergierbar werdenden photopolymerisierbaren und/oder photovernetzbaren Materials, dadurch gekennzeichnet, daß das photopolymerisierbare und/oder photovernetzbare Material zumindest in einer Oberflächenzone von 1 bis 50 μm der Oberfläche der Schicht (S), die die spätere Oberfläche der Druckform bildet, feinteilige, abrasive Partikel in einer solchen Menge enthält, daß diese 2 bis 50 Gew.% des diese Partikel enthaltenden photopolymerisierbaren und/oder photovernetzbaren Materials betragen, wobei die mittlere Teilchengröße der abrasiven Partikel im Bereich von 0,1 bis 6 μm liegt, höchstens 5 % der abrasiven Partikel Längsausdehnungen größer 10 μm aufweisen und die abrasiven Partikel eine Härte von > 4,0 auf der Mohs'schen Härteskala besitzen ; und daß die Oberfläche der Schicht (S), die die spätere Oberfläche der Druckform bildet, eine Rauhtiefe von < 2 μm besitzt und daß die Bestandteile des photopolymerisierbaren und/oder photovernetzbaren Materials der Schicht (S) so gewählt werden, daß diese Schicht nach der Belichtung, Entwicklung und Trocknung mindestens in dem die farbaufnehmenden Vertiefungen enthaltenden Schichtdickenbereich eine unter Last gemessene Vickers-Härte von mindestens 10 N/mm$^2$ besitzt.

2. Lichtempfindliches Aufzeichnungsmaterial gemäß Anspruch 1, dadurch gekennzeichnet, daß die feinteiligen abräsiven Partikel für aktinisches Licht durchlässig sind und die Brechungsindices der feinteiligen abräsiven Partikel und des diese Partikel enthaltenden photopolymerisierbaren und/oder photovernetzbaren Materials aneinander angeglichen sind.

3. Lichtempfindliches Aufzeichnungsmaterial gemäß Anspruch 1, dadurch gekennzeichnet, daß die Brechungsindices der feinteiligen abräsiven Partikel und des diese Partikel enthaltenden photopolymerisierbaren und/oder photovernetzbaren Materials aneinander angeglichen sind ; die feinteiligen abräsiven Partikel für aktinisches Licht stark absorbierend sind und in der Schicht (S) nur bis zu einer Schichttiefe von 1 bis 50 μm, vorzugsweise 5 bis 20 μm, gemessen von der Oberfläche der Schicht (S), die die spätere Oberfläche der Druckform bildet, enthalten sind.

4. Lichtempfindliches Aufzeichnungsmaterial gemäß Anspruch 1, dadurch gekennzeichnet, daß die Brechungsindices der feinteiligen abräsiven Partikel und des photopolymerisierbaren und/oder photovernetzbaren Materials nicht aneinander angepaßt sind und die aktinisches Licht absorbierenden und/oder nicht absorbierenden, feinteiligen, abräsiven Partikel in der Schicht (S) nur bis zu einer Schichttiefe von 1 bis 50 μm, vorzugsweise 5 bis 20 μm, gemessen von der Oberfläche der Schicht (S), die die spätere Oberfläche der Druckform bildet, enthalten sind.

5. Lichtempfindliches Aufzeichnungsmaterial nach Ansprüchen 1 bis 4, dadurch gekennzeichnet, daß das photopolymerisierbare und/oder photovernetzbare Material mindestens in der die abräsiven Partikel enthaltenden Zone der Schicht (S) als Photopolymerisationsinitiator neben einem niedrig absorbierenden Photopolymerisationsinitiator mit einem Extinktionskoeffizient ε bei 360 nm von < 350 cm$^2$/mMol zusätzlich einen stark absorbierenden Photopolymerisationsinitiator mit einem Extinktionskoeffizienten ε bei 360 nm von mehr als 500 cm$^2$/mMol enthält.

6. Lichtempfindliches Aufzeichnungsmaterial gemäß Ansprüchen 1 bis 5, dadurch gekennzeichnet, daß der dimensionsstabile Träger ein temporärer Träger aus einer Polyester-Folie ist.

7. Verfahren zur Herstellung von Tiefdruckformen durch Belichten eines lichtempfindlichen Aufzeichnungsmaterials mit einer photopolymerisierbaren und/oder photovernetzbaren Schicht (S) auf einem dimensionsstabilen Träger mit aktinischem Licht durch ein Raster- oder Strich-Positiv oder durch ein Halbton-Positiv und eine Führungsraster-Vorlage, anschließendes Auswaschen der nicht belichteten Anteile der Schicht (S) mit Hilfe einer Entwicklerflüssigkeit, in der die nicht belichteten Anteile, nicht aber die belichteten Anteile der Schicht (S) löslich oder dispergierbar sind, sowie Trocknen und gegebenenfalls Nachbehandlung der erhaltenen Tiefdruckform, dadurch gekennzeichnet, daß man zur Herstellung der Tiefdruckformen ein lichtempfindliches Aufzeichnungsmaterial gemäß Ansprüchen 1 bis 6 einsetzt.

8. Verfahren zur Herstellung von Tiefdruckformen gemäß Anspruch 7, dadurch gekennzeichnet, daß man für die Herstellung ein lichtempfindliches Aufzeichnungsmaterial gemäß Anspruch 6 verwendet, wobei die Schicht (S) vor oder nach der Belichtung auf einen vorzugsweise mit einer Haftschicht versehenen Druckformträger aufkaschiert wird und die Polyester-Folie anschließend, spätestens jedoch vor dem Auswaschen abgezogen wird.

9. Verfahren zur Herstellung von Tiefdruckformen gemäß Ansprüchen 7 und 8, dadurch gekennzeichnet, daß die Tiefdruckformen nach dem Auswaschen und Trocknen vollflächig mit aktinischem Licht nachbelichtet werden.

10. Verfahren zur Herstellung von Tiefdruckformen gemäß den Ansprüchen 7 bis 9, dadurch gekennzeichnet, daß die Tiefdruckformen nach dem Auswaschen der unbelichteten Anteile und Trocknen sowie gegebenenfalls der Nachbelichtung bei einer Temperatur im Bereich von 200 °C bis 260 °C nachgehärtet werden.

**Claims**

1. A photosensitive recording material for the production of a gravure printing plate, which comprises a 30-500 μm thick layer (L) which is applied to a dimensionally stable base and contains a photopolymerizable and/or photocrosslinkable material which is soluble or dispersible in a developer and becomes insoluble or non-dispersible therein when exposed to actinic light, wherein the photopolymerizable and/or photocrosslinkable material contains, at least in a surface zone having a thickness of from 1 to 50 μm, measured from the surface of the layer (L), which subsequently constitutes the surface of the printing plate, finely divided, abrasive particles in an amount of from 2 to 50 % by weight, based on the photopolymerizable and/or photocrosslinkable material containing these particles, the mean particle size being from 0.1 to 6 μm, not more than 5 % of the abrasive particles have a maximum particle size greater than 10 μm, the particles have a hardness of > 4.0 on Mohs' hardness scale, the surface of the layer (L), which subsequently constitutes the surface of the printing plate, has a peak-to-valley height of < 2 μm, and the components of the photopolymerizable and/or photocrosslinkable material of the layer (L) are so chosen that this layer, after exposure, development and drying, has a Vickers hardness, measured under load, of not less than 10 N/mm², at least to the depth of the wells which take up the ink.

2. A photosensitive recording material as claimed in claim 1, wherein the finely divided, abrasive particles are permeable to actinic light, and the refractive indices of the finely divided abrasive particles and of the photopolymerizable and/or photocrosslinkable material containing these particles are substantially the same.

3. A photosensitive recording material as claimed in claim 1, wherein the refractive indices of the finely divided, abrasive particles and of the photopolymerizable and/or photocrosslinkable material containing these particles are substantially the same, and the finely divided, abrasive particles strongly absorb actinic light, and are present in the layer (L) only to a depth of from 1 to 50 μm, preferably from 5 to 20 μm, measured from the surface of the layer (L), which subsequently constitutes the surface of the printing plate.

4. A photosensitive recording material as claimed in claim 1, wherein the refractive indices of the finely divided, abrasive particles and of the photopolymerizable and/or photocrosslinkable material are different, and the finely divided, abrasive particles which absorb actinic light and/or those which do not absorb actinic light are present in the layer (L) only to a depth of from 1 to 50 μm, preferably from 5 to 20 μm, measured from the surface of the layer (L), which subsequently constitutes the surface of the printing plate.

5. A photosensitive recording material as claimed in claims 1 to 4, wherein the photopolymerizable and/or photocrosslinkable material contains, at least in the zone of the layer (L) which contains the abrasive particles, a weakly absorbing photopolymerization initiator with an extinction coefficient $\varepsilon$ of $< 350$ cm²/millimole at 360 nm as well as a strongly absorbing photopolymerization initiator with an extinction coefficient $\varepsilon$ of more than 500 cm²/millimole at 360 nm.

6. A photosensitive recording material as claimed in claims 1 to 5, wherein the dimensionally stable base is a temporary base made from polyester film.

7. A process for the production of a gravure printing plate by exposing a photosensitive recording material, comprising a photopolymerizable and/or photocrosslinkable layer (L) on a dimensionally stable base, to actinic light through a halftone or line positive or through a continuous tone positive and a screen grid, washing out the non-exposed areas of the layer (L) by means of a developer in which these areas, but not the exposed areas, of the layer (L) are soluble or dispersible, and drying and optionally aftertreating the resulting gravure printing plate, wherein a photosensitive recording material as claimed in claims 1 to 6 is used to produce the gravure printing plate.

8. A process for the production of a gravure printing plate, as claimed in claim 7, wherein a photosensitive recording material as claimed in claim 6 is used to produce the plate, the layer (L) being laminated, before or after exposure, onto a printing plate base, which is preferably provided with an adhesive layer, and the polyester film is then peeled off, this last step being carried out before washout.

9. A process for the production of a gravure printing plate, as claimed in claims 7 and 8, wherein the whole surface of the gravure printing plate is after-exposed to actinic light, after the plate has been washed out and dried.

10. A process for the production of a gravure printing plate, as claimed in claims 7 to 9, wherein the gravure printing plate is after-hardened at from 200 °C to 260 °C, after the unexposed areas have been washed out and the plate dried, and after any after-exposure step.

## Revendications

1. Matériau d'enregistrement photosensible pour la fabrication de formes d'impression par héliogravure, comprenant une couche (S), d'une épaisseur de 30 à 500 μm, d'une matière photopolymérisable et(ou) photoréticulable, soluble ou dispersable dans un liquide révélateur, mais devenant insoluble ou indispersable dans ce liquide révélateur par exposition à de la lumière actinique, cette couche étant déposée sur un support dimensionnellement stable, caractérisé en ce que la matière photopolymérisable et(ou) photoréticulable comprend, au moins dans une zone superficielle d'une épaisseur de 1 à 50 μm de la surface de la couche (S), qui doit constituer la face supérieure de la forme d'impression, de fines particules abrasives en une proportion telle qu'elles constituent 2 à 50 % du poids de la matière photopolymérisable et(ou) photoréticulable, qui les contient, la granulométrie moyenne de ces particules abrasives se situant dans la gamme de 0,1 à 6 μm et 5 % au plus de ces particules abrasives possédant une dimension longitudinale supérieure à 10 μm, la dureté de ces particules abrasives étant supérieure à 4,0 sur l'échelle des duretés de Mohs, la surface de la couche (S) devant constituer la face supérieure de la forme d'impression possède une profondeur de rugosité inférieure à 2 μm et les composants de la matière photopolymérisable et(ou) photoréticulable sont choisis de telle façon que cette couche possède après l'exposition à la lumière, le développement et le séchage, au moins dans la partie de la couche comprenant les creux recevant l'encre, une dureté Vickers, mesurée sous une charge, d'au moins 10 N/mm².

2. Matériau d'enregistrement photosensible suivant la revendication 1, caractérisé en ce que les fines particules abrasives sont transparentes pour la lumière actinique et les indices de réfraction de ces particules et de la matière photopolymérisable et(ou) photoréticulable, qui les contient, sont adaptés l'un à l'autre.

3. Matériau d'enregistrement photosensible suivant la revendication 1, caractérisé en ce que les indices de réfraction des fines particules et de la matière photopolymérisable et(ou) photoréticulable, qui les contient, sont adaptés l'un à l'autre, les fines particules abrasives absorbent fortement la lumière actinique et ne sont contenues dans la couche (S) que sur une profondeur de 1 à 50 et de préférence de 5 à 20 μm, mesurée à partir de la surface de la couche (S) devant constituer la face supérieure de la forme d'impression.

4. Matériau d'enregistrement photosensible suivant la revendication 1, caractérisé en ce que les indices de réfraction des fines particules abrasives et de la matière photopolymérisable et(ou) photoréticulable, qui les contient, ne sont pas adaptés l'un à l'autre et les fines particules abrasives, qui absorbent ou n'absorbent pas la lumière actinique, ne sont contenues dans la couche (S) que sur une profondeur de 1 à 50 et de préférence de 5 à 20 μm, mesurée à partir de la surface de la couche (S) devant constituer la face supérieure de la forme d'impression.

5. Matériau d'enregistrement photosensible suivant les revendications 1 à 4, caractérisé en ce que la matière photopolymérisable et(ou) photoréticulable contient, au moins dans la partie de la couche (S) contenant les particules abrasives, à côté d'un initiateur de la photopolymérisation peu absorbant avec un coefficient d'extinction ε inférieur à 350 cm²/millimole à 360 nm, un autre initiateur de la photopolymérisation fortement absorbant avec un coefficient d'extinction ε supérieur à 500 cm²/millimole à 360 nm.

6. Matériau d'enregistrement photosensible suivant les revendications 1 à 5, caractérisé en ce que le support dimensionnellement stable est un support temporaire en une feuille en polyester.

7. Procédé de fabrication de formes d'impression par héliogravure par exposition d'un matériau d'enregistrement photosensible, constitué d'une couche (S) photopolymérisable et(ou) photoréticulable sur un support dimensionnellement stable, à la lumière actinique à travers un positif tramé ou au trait ou à travers un positif à demi- teinte et un original à trame de guidage, suivie de l'élimination des parties non exposées de la couche (S) par lavage avec un liquide révélateur, dans lequel les parties non exposées sont solubles et les parties exposées de la couche (S) ne sont ni solubles, ni dispersables, du séchage et éventuellement d'un post-traitement de la forme d'impression par héliogravure produite, caractérisé en ce que l'on emploie pour la fabrication des formes d'impression par héliogravure un matériau d'enregistrement photosensible suivant les revendications 1 à 6.

8. Procédé de fabrication de formes d'impression par héliogravure suivant la revendication 7, caractérisé en ce que l'on emploie un matériau d'enregistrement photosensible suivant la revendication 6, la couche (S) étant appliquée, avant ou après l'exposition à la lumière, sur un support pour la forme d'impression, de préférence pourvue d'une couche d'adhérence, et la feuille en polyester est enlevée ensuite, au plus tard avant le lavage.

9. Procédé de fabrication de formes d'impression par héliogravure suivant les revendications 7 et 8, caractérisé en ce que les formes d'impression par héliogravure sont soumises, après le lavage et le séchage, à une post-exposition totale à de la lumière actinique.

10. Procédé de fabrication de formes d'impression par héliogravure suivant les revendications 7 à 9, caractérisé en ce que, après l'élimination par lavage des parties non exposées à la lumière et le séchage et de la post-exposition éventuelle à la lumière, les formes d'impression par héliogravure sont soumises à une post-réticulation à une température dans la gamme de 200 à 260 °C.